# EUROPEAN PATENT APPLICATION

(11) **EP 1 582 883 A1**
(43) Date of publication of application: **05.10.2005**
(21) Application number: 03780182.6
(22) Date of filing: 15.12.2003
(51) Int. Cl.: G01R 31/28, G01R 31/317, G01R 31/319

(54) **METHOD OF INDUCING A STATE IN A HARDWARE EMULATION CIRCUIT**

(30) Priority: 20.12.2002 ES 200203051
(71) Applicant: UNIVERSIDAD DE SEVILLA, 41013 Sevilla (ES)
(72) Inventor: AGUIRRE ECHANOVE, Miguel,, E-41092 Sevilla (ES); TOMBS, Jonathan, Noel, E-41092 Sevilla (ES); TORRALBA SILGADO, Antonio, E-41092 Sevilla (ES); GARCIA FRANQUELO, Leopoldo, E-41092 Sevilla (ES)
(74) Representative: Temino Ceniceros, Ignacio
(86) International application number: PCT/ES2003/000633
(87) International publication number: WO 2004/057352

(57) **Abstract**

The invention relates to a method of inducing a state in a hardware emulation circuit. The inventive method is based on user-programmable digital integrated circuits comprising different configuration mechanisms, which are configured, for example, using volatile memory cells (11 and 12). The method is used to manipulate specific points of a hardware emulator, such as to configure different elements locally without affecting the rest of the system. Using a circuit which is in a state that is insensitive to the activity of the clock together with the intensive use of a clock-enabling input, said method consists in inducing the initialisation value in the registry, equal to the desired value, by manipulating a volatile memory (12) which configures a decoder (10), changing the desired polarity value of the initialisation signal, manipulating another volatile memory (11) which configures a multiplexer (9), restoring the configuration conditions that existed prior to the manipulation and releasing the circuit from the frozen state, thereby activating the clock-enabling signal (3).

## Description

### OBJECT OF THE INVENTION

This invention is a procedure for making modifications to the behaviour of a digital circuit that is emulated on a commercial hardware emulation system, also referred to as FPGA, by inducing values in any register of the circuit, and doing so at any moment when it is operating and through methods that are different to the natural development of the circuit, the invention being valid for any of the hardware emulators on the market that are based upon memories and it is based upon the original use of the elements that constitute those emulators, and in a way that is not envisaged by the manufacturers.

The procedure enables the user to enter a value in any of the registers that have not been selected beforehand, and to do so at operating times that have not been planned on a digital circuit that is being tested (CDBP) that is supported in the emulator and without enabling specific circuitry. That is to say, it enables the user to enter values that are unexpected or operating errors by means of a suitable control over the emulator itself. The modification to the state of a register is a process that describes the effect of an adverse event that affects one single bit, i.e. a "single bit upset event" or SBUE. The SBUE model represents the potential effects on an integrated digital circuit in extreme environmental conditions.

### BACKGROUND TO THE INVENTION

One of the most important and problematic points in many of the integrated circuits that are designed for applications of great responsibility (life support applications, assistance in driving aircraft or spacecraft, space publications, etc.) is verifying the potential errors caused by the extreme operating conditions to which they are subjected. At present, the studies that are being conducted are based upon statistical procedures for inserting SBUEs into simulated models. From a practical viewpoint, it is not feasible to verify all the possible events.

The hardware emulators that are currently available on the market do not directly provide a solution to this problem.

At present, the studies are conducted on simulated systems using extremely powerful computers. The number of simulations that have to be conducted is very high, in view of the fact that each introduction of one single SBUE requires a complete simulation of the circuit. The current systems produce solutions in a way that is inefficient and they take a long time to find these solutions, and the greater the circuit is the longer they take to find an answer. Therefore, a more complex circuit has a negative effect on the efficiency of such methods.

In view of this, the current invention does not concern itself with how to construct the emulation system to produce single bit upset events (SBUEs), but devises a procedure for making SBUEs in any commercial emulator.

### DESCRIPTION OF THE INVENTION

The subject of this invention is a sequence of operations that must be carried out to induce values into the registers of a digital circuit that is being tested (CDEP). The procedure is based upon the suitable manipulation of the configuration memories of the elements that form part of an elementary programmable block of those that make up a hardware emulator.

The procedure that is the subject of this invention can use the circuitry and the procedure that is described in invention P200102683. In it, a description is given of how to control the development of the circuit by setting it in the "frozen" state. In this situation the procedure that is described in this invention is feasible, and it is possible to induce any initial value into the register as well as being able to allow the initialisation signal to have one polarity or another. Both pxopex-bies are absolutely common in the emulators that are currently available on the market.

The procedure that is the subject of this invention consists of inducing the known values by using the initialisation mechanism of a register by manipulating the original value of the register, transforming it into the value that the user wishes to induce, and also transforming the polarity of the signal that enables that initial value, by locally activating that signal.

### DESCRIPTION OF THE DRAWINGS

With a view to helping to give a better understanding of the characteristics of the invention, in accordance with an example of a preferred embodiment of a practical realisation thereof, the description that is being given is supplemented with one single page of plans that is enclosed and forms an essential part of that description, by way of illustrating it but not in an exhaustive way, and the sketch is of a block diagram that shows the programmable resources that are involved in the procedure used in the invention.

### REALISATION OF A PREFERRED EMBODIMENT OF THE INVENTION

It can be seen from the figures that are shown, how the aforementioned block diagram features a register (1) whose purpose is to induce the value that is associated with the clock signal for the register (2), the clock-enabling signal (3) for the clock, the signal for the future value of the contents of the register after the clock's action (4) and the signal for the value of the register's contents (5). The "reset" signal (6) gains access to the block for the register's signal (2) that induces the value, activates the value zero on a low level and initialisation, and the "set" signal (7) activates the value one on a low level and initialisation, signals coming from the decomposition of the global initialisation signal (8) that is made to pass through a multiplexer (9) whose state is consistent with the polarity of the initialisation signal, and after this multiplexer (9) there is a decoder (10) whose state indicates the initialisation value, these being associated with the block for the multiplexer (9) and the block for the decoder (10) the two blocks (11) and (12) respectively corresponding to a configuration memory cell that establishes the state of the multiplexer (9) and a configuration memory cell that establishes the state of the decoder (10).

The hardware emulator circuits are characterised by the fact that they can adopt whatever functionality the user wishes by generating a suitable configuration pattern. These circuits are known on the market as Field Programmable Gate Arrays or FPGAs, and they are integrated digital circuits that can be programmed by the user. These circuits have different configuration mechanisms depending on the model concerned. We are specifically referring to those circuits that are configured by means of volatile memory cells (or SRAM), (11) and (12), which account for more than 80 % of the world market share. The ability either to configure themselves an infinite number of times or to reconfigure themselves and undergo modifications to their structure while they are operating in a normal way, is one possibility that is not ignored by the manufacturers.

This makes the hardware emulators extremely flexible in the structure of the digital circuit that they emulate. However, this flexibility is not sufficient. There are situations in which it is extremely useful to make changes to the state of a circuit, that is to say, to make modifications to the contents of the internal registers at a particular moment in time. These changes mean that values are induced into the registers that are not consistent with the ortes that they have to make at the time they are made. In view of the general way in which hardware emulators are constructed, it is possible to locally configure the different elements without this affecting the rest of the system. This means that it is possible to manipulate specific points of the emulating circuit.

In this invention, we are taking advantage of the fact that hardware emulators are normally equipped with the following:
a) A global initialisation signal (8) for the registers, whose active polarity can be programmed. That is to say, the register is invariably initialised in the same way, with the same polarity in the signals (6) and (7) but the user can indicate which one he prefers. The system is adapted to the requirements of the designer by means of a multiplexer and an inverter (9).
b) A, specific initialisation value ( set / reset ) (7) - (6) for each register, that is to say, the register can go irrespectively to any value that is programmed in (12) by the designer when the initialisation signal (8) is activated.

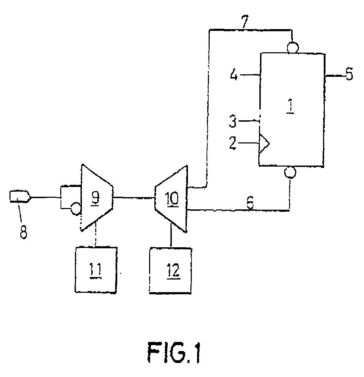

The figure shows a register in diagram form, together with its initialisation value and how the initialisation value can be adapted. Normally these signals are only useful when start-up or circuit reinitialising operations are being carried out.

Therefore, the invention consists of a procedure or method so that, by using the potential of this initialisation system, it is possible to modify the value that is contained in any register for the emulated design. The procedure consists of the following steps:
1. By using a system that is in itself known, the circuit has to be insensitive to the activity of the clock (2) and must remain static, without evolving, that is to say, "frozen". With a view to this, it is proposed that the clock-enabling input (3) be intensively used. This clock-enabling input is available on all the existing emulators.
2. Inducing the initialisation value into the register that is equivalent to the value that the user wishes to induce. Manipulating the memory (12) that configures the decoder (10)
3. Making a change in the polarity value desired in the initialisation signal, manipulating the memory (11), which configures the multiplexer (9). This change forces the register to evolve to the initialisation state, in view of the fact that this initialisation signal (8) remains invariable.
4. Reverting to the configuration conditions before the manipulation, writing the original values in (11) and (12).
5. Releasing the circuit from the frozen state, activating the clock-enabling signal (3).

## Claims

1. A procedure for inducing the values into the registers of an emulated digital circuit by means of an integrated hardware emulation circuit, the aim of which is to conduct a test and to carry out a statistical study of the adverse effects of single bits on digital circuits that are executed in hardware emulators. It is **characterised by** the fact that it consists of inducing the initialisation value into the register that is equivalent to the value that the user wishes to induce, by first manipulating a volatile memory (12) that configures a decoder (10), then modifying the desired polarity value in the initialisation signal (8). Secondly, manipulating a second volatile memory (11) that configures a multiplexer (9), and also manipulating the polarity of the signal that forces this initialisation locally. Both of these modifications force the register to evolve to the state of initialisation, but they do not affect the rest of the functionality of the circuit, where the initialisation signal (8) remains invariable. Thirdly, it carries out a process of reverting to the configuration conditions that existed before the manipulation on the basis of the original values of the volatile memories (11) and (12). Finally, the circuit is released from its "frozen" state by activating the clock-enabling signal (3).
